# EUROPEAN PATENT APPLICATION

(11) **EP 1 885 058 A1**
(43) Date of publication of application: **06.02.2008**
(21) Application number: 06291265.4
(22) Date of filing: 03.08.2006
(51) Int. Cl.: H03F 1/56, H04B 1/04, H03G 3/30

(54) **Method of controlling amplifier gain and amplifier stage**

(71) Applicant: Alcatel Lucent, 75008 Paris (FR)
(72) Inventor: Wiegner, Dirk, 71409 Schwaikheim (DE); Seyfried, Ulrich, 71282 Hemmingen (DE); Klose, Peter, 71229 Höfingen (DE)
(74) Representative: Kohler Schmid Möbus

(57) **Abstract**

A method of controlling gain of an amplifier (1). The proposed method comprises:
- providing an adaptive matching network with a plurality of adaptive matching branches (6.1, 6.2, 6.3), each adaptive matching branch being intended for a specific frequency;
- biasing a first switching element (8.1, 8.2, 8.3) or a first tuneable element comprised in an adaptive matching branch (6.1, 6.2, 6.3) for a given frequency in a first state;
- biasing respective switching elements (8.1, 8.2, 8.3) or tuneable elements comprised in adaptive matching branches (6.1, 6.2, 6.3) for other frequencies in a second state;

in order to adjust amplifier gain and to optimise amplifier performance.

## Description

### Background of the invention

The present invention relates to a method of controlling gain of an amplifier.

The present invention also relates to an amplifier stage, in particular for amplifying radio frequency (RF) signals.

The present invention further relates to a transmitter, in particular radio transmitter, and to a base station or mobile terminal for use in a communication network.

For applications like software-defined radio (SDR), different frequency bands and standards have to be covered by means of a single base transceiver station (BTS). In order to realise a BTS capable of supporting multi-band/multi-standard communication, multi-band power amplifier modules are required in a transmission path of the BTS frontend.

In the prior art, variable attenuators or variable gain amplifiers have been used in multi-band power amplifier modules in order to influence at least one of an overall gain characteristic, output power level, and amplifier module efficiency for each addressed frequency band of multi-band/multi-standard amplifier modules. This solution suffers from the inherent disadvantage of requiring an additional component (i.e., variable gain amplifier or variable attenuator) within the amplifier module, which entails increased cost expenditure.

### Object of the invention

It is the object of the present invention to provide a method of the above-defined type and an amplifier stage for improving at least one of an overall gain characteristic, an output power level, and an efficiency of a multi-band/multi-standard amplifier or amplifier module which does not require said additional component and is thus more cost-effective than the prior art.

### Summary of the invention

According to a first aspect of the present invention the object is achieved by providing a method of controlling gain of an amplifier, comprising providing an adaptive matching network with a plurality of adaptive matching branches, each adaptive matching branch being intended for a specific frequency; biasing a first adaptive matching element comprised in an adaptive matching branch for a given frequency in a first state; and biasing respective adaptive matching elements comprised in adaptive matching branches for other frequencies in a second state.

Said adaptive matching elements can be devised as, e.g., switching elements, in particular diodes, or tuneable elements, in particular tuneable capacitors (MEMS).

According to a second aspect of the present invention the object is achieved by providing an amplifier stage, in particular for amplifying RF signals, comprising an input for inputting a signal to be amplified; an output for outputting an amplified signal; an amplifying element located in a signal transmission path between said input and said output; an adaptive matching network with a plurality of adaptive matching branches, each adaptive matching branch being intended for a specific frequency; further comprising in each adaptive matching branch a switching element for activating/deactivating the respective adaptive matching branch or a tuneable element for adjustment of a suitable matching of a respective matching branch; and biasing means for biasing said switching elements or said tuneable elements in at least a first and a second state.

According to a third aspect of the present invention the object is achieved by providing a transmitter, in particular a radio transmitter, comprising at least one amplifier stage according to said second aspect of the present invention.

According to a fourth aspect of the present invention the object is achieved by providing a base station or a mobile station for use in a communication network, comprising at least one transmitter according to said third aspect of the present invention.

Thus, in accordance with the present invention, a switchable matching network based on switchable components is used for suitable matching of the amplifying means (e.g., power transistor) to each intended frequency or frequency band. Suitable switching elements which can be used for the described applications are, for instance, PIN (positive intrinsic negative) diodes, which show low parasitics and withstand power levels of currently up to 10 W, which is enough for adaptive input matching of a 100 W peak output power amplifier stage providing ≥ 10 dB gain. An adaptive matching network of this kind can be used for any one or a combination of pre-, driver, and final amplifier stages.

In order to operate the amplifier at a certain intended frequency or frequency band, a corresponding switching element (PIN diode) has to be biased in an On-state, so that a corresponding switched matching element (e.g., a capacitor) is active in the adaptive matching network. The other switching elements in the adaptive matching network accordingly are usually biased in an Off-state.

In this way, in an embodiment of the method in accordance with the present invention at least one of said adaptive matching elements is a switching element and said first state is an On-state. Alternatively, in another embodiment of the method in accordance with the present invention at least one of said adaptive matching elements is a switching element and said first state is an intermediate state between an On-state and an Off-state. This allows for varying the power amplifier gain within a certain value range in order to optimise amplifier performance. In other words: The biasing of this state is chosen such that the gain is suitably aligned for each specific frequency band in order to optimise the whole amplifier performance for each addressed frequency band.

In another embodiment of the method in accordance with the present invention the latter further comprises determining a biasing condition of at least one of the adaptive matching elements from a look-up table, wherein a choice of the at least one adaptive matching element depends on the addressed frequency band.

Alternatively or additionally, in yet another embodiment of the method in accordance with the present invention the latter may further comprise analysing an output signal of the amplifier to determine a biasing condition of at least one of the adaptive matching elements. This enables accurate dynamical control of adaptive matching characteristics in order to align the gain suitably for a specific addressed frequency band.

In a corresponding embodiment of the amplifier stage in accordance with the present invention the latter further comprises means for controlling a biasing condition of said switching element or said tuneable elements.

As already stated above, in accordance with a further embodiment of the amplifier stage in accordance with the present invention said controlling means may comprise a look-up table with stored bias conditions for each of the adaptive matching elements. Alternatively or additionally, in another embodiment of the amplifier stage in accordance with the present invention, the latter may comprise means for analysing an output signal of the amplifier stage to determine bias conditions for each of the adaptive matching elements. Said analysing means may be comprised in a feedback path of the amplifier stage.

In yet another embodiment of the amplifier stage in accordance with the present invention, particularly if said adaptive matching elements are devised as switching elements, each adaptive matching branch comprises a further matching element, e.g. a capacitor, connected in parallel with said signal transmission path. A position of each adaptive matching branch on the signal transmission path and/or a value of said matching element can be determined in order to achieve suitable adaptive matching, as known to a person skilled in the art.

As already stated above, in another embodiment of the amplifier stage in accordance with the present invention said switching elements are diodes, in particular PIN diodes.

A preferred use of the amplifier stage in accordance with the present invention is use as a power amplifier stage in a (multi-stage) amplifier module. Such amplifier modules can be used in base stations or mobile terminals for multi-band/multi-standard radio communication networks.

For adaptive input matching, in accordance with another embodiment of the amplifier stage in accordance with the present invention at least one adaptive matching branch is located upstream of the amplifying elements.

For adaptive output matching, in yet another embodiment of the amplifier stage in accordance with the present invention at least one adaptive matching branch is located downstream of the amplifying element, if the required switching elements can withstand the relevant power levels

Further advantages and characteristics of the present invention can be gathered from the following description of preferred embodiments given by way of example only with reference to the enclosed drawings. Features mentioned above as well as below can be used in accordance with the present invention either individually or in conjunction. The described embodiments are not to be regarded as an exhaustive enumeration but rather as examples with respect to a basic idea underlying the present invention.

### Brief description of the drawings

- Fig. 1: is a schematic diagram of an embodiment of the amplifier stage in accordance with the present invention;
- Fig. 2: is a diagram showing input reflection and gain of the amplifier stage of Fig. 1 for a first bias condition at a given frequency; and
- Fig. 3: is a diagram showing input reflection and gain of the amplifier stage of Fig. 1 for a second bias condition at a given frequency.

### Detailed description

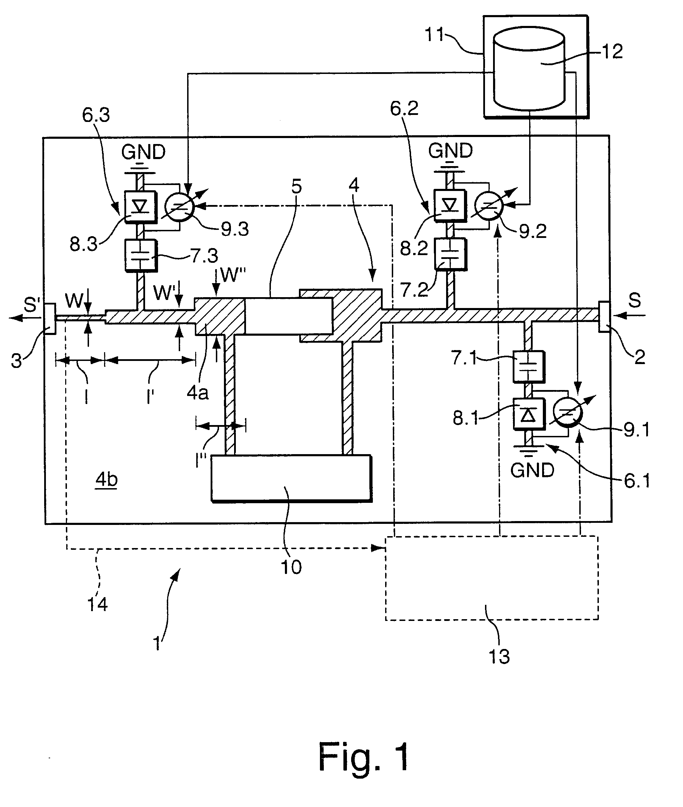

Fig. 1 shows a schematic diagram of an amplifier stage 1 in accordance with an embodiment of the present invention. The amplifier stage, which can be used as a pre-, driver, and/or final amplifier stage within a multistage amplifier module, comprises an input 2 for inputting an RF signal S to be amplified. Amplifier stage 1 further comprises an output 3 for outputting an amplified signal S'. Input 2 and output 3 are electrically connected by means of signal transmission path 4 comprising an amplifying element 5 in form of a power transistor, i.e. a transistor package in the form of a surface-mounted device (SMD). Signal transmission path 4 is devised in the form of a (printed) conductor layer 4a (hashed areas in Fig. 1), which can have varying widths, e.g., denoted W, W', W", ..., and lengths I', I", I"', ... for input and/or output impedance matching, as known to a person skilled in the art. Conductor layer 4a is disposed on a suitable substrate 4b.

In parallel with said signal transmission path 4, amplifier stage 1 further comprises a plurality of adaptive matching branches 6.1, 6.2, 6.3 which constitute an adaptive matching network. As can be gathered from Fig. 1, adaptive matching branches 6.1, 6.2 are located on an input side of amplifier stage 1, whereas adaptive matching branch 6.3 is located on an output side of amplifier stage 1. The use of adaptive matching branch 6.3 depends on amplifier output power level and power capability of the matching and switching elements.

Each adaptive matching branch 6.1-6.3 comprises an impedance matching means or matching element 7.1, 7.2, 7.3, e.g. in the form of a capacitor, and an adaptive matching element devised as a switching element 8.1, 8.2, 8.3 in the form of a PIN diode connected in series with said matching means 7.1-7.3. An end of each adaptive matching branch 6.1-6.3 is grounded GND. Each adaptive matching branch 6.1-6.3 is provided with a biasing means 9.1, 9.2, 9.3 in the form of a tuneable or controllable voltage generator for supplying a biasing voltage to the associated PIN diode 8.1-8.3.

In operative connection with power transistor 5 there is further provided an amplifier biasing means 10, as known to a person skilled in the art.

As can be gathered from Fig. 1, amplifier stage 1 further comprises memory means 11 comprising a look-up table 12 in operative connection with biasing means 9.1-9.3. Alternatively or additionally, amplifier stage 1 may also comprise output signal analysing means 13 located in a feedback path 14 for receiving output signal S' of amplifier stage 1. As further indicated in Fig. 1, analysing means 13 is also operatively connected with voltage generators 9.1-9.3.

According to the embodiments of Fig. 1, amplifier stage 1 is particularly suited for use as power amplifier stage for use in a transmitter of a multi-band/multi-standard base station or mobile terminal in a communication network, in particular a communication network based on software-defined radio (SDR) technology.

In the above-described application, different frequency bands and standards have to be covered by means of a single base transceiver station (BTS). As already stated above, in order to realise a BTS capable for use in a multi-band/multi-standard communication network, multi-band power amplifier modules are required in the transmit path of the BTS frontend. However, wideband or multi-band power amplifiers, i.e., pre-, driver- and/or final amplifier stages, often show frequency-dependent gain ripple due to the wide frequency range of several 100 MHz which has to be covered.

in order to improve the performance of a multi-band/multi-standard BTS, it is proposed to devise at least a final amplifier stage in a corresponding multi-band power amplifier module as described above with reference to appended Fig. 1.

### Operation of amplifier stage 1 according to Fig. 1 will now be described in detail:

In the matching network of amplifier stage 1 switching elements 8.1-8.3 are used for suitable matching of power transistor 5 to each intended frequency band within a multi-band frequency range. As already stated above, switching elements 8.1-8.3 are advantageously devised in the form of PIN (positive intrinsic negative diode), which show low parasitics and can withstand elevated power levels.

In an alternative embodiment of the present invention, adaptive matching elements in the form of, e.g., tuneable capacitors (MEMS) could be used instead of switching elements 8.1-8.3 and respective matching capacitors 7.1-7.3, thus providing similar possibilities.

For reason of clarity, in Fig. 1 only two adaptive matching branches of said adaptive matching network, i.e., matching branches 6.1, 6.2, are shown in connection with the input matching part of amplifier stage 1. For instance, adaptive matching branches 6.1, 6.2 could be intended for matching of amplifier stage 1 at 900 MHz and 2500 MHz, respectively. As will be appreciated by a person skilled in the art, extended multi-band amplifier modules covering more than two frequency bands may comprise additional adaptive matching branches, at least one adaptive matching branch for each covered frequency band. Note that for directly adjacent frequency bands a single adaptive matching branch may suffice for a plurality of frequency bands, e.g., two frequency bands.

As known to a person skilled in the art, an exact position of a matching branch on signal transmission path 4 as well as a type and value of the matching element (capacitor) 7.1-7.3 depends on the covered frequency range and the used transistor itself.

As will further be appreciated by a person skilled in the art, up to an allowed power level of the switching elements (PIN diodes) 8.1-8.3 used, the adaptive matching branches 6.1-6.3 of Fig. 1 can also be used for output matching, e.g., for P1dB (1 dB compression point) adaptation in the context of gain compression, as illustrated in exemplary fashion by means of matching branch 6.3 of Fig. 1.

For adaptive matching, i.e., in order to operate amplifier stage 1 at a certain intended frequency range (e.g., in a multi-band/multi-standard BTS), the switching element (e.g., switching element 8.1) related to that particular frequency or frequency band has to be biased in a first state, which in the case of a PIN diode can be identified with an On-state in accordance with an embodiment of the present invention. In this way, the associated switched matching element (e.g., capacitor 7.1) is activated in the adaptive matching network. At the same time, the PIN diodes 8.1, 8.3 in the adaptive matching branches 6.2, 6.3 of other frequency bands - which are currently not intended to be covered - are usually biased in a second state. In the present example, said second state can be identified with an Off-state.

In the embodiment of Fig. 1, biasing said switching elements 8.1-8.3 is achieved by means of the respective adjustable voltage generator (biasing means) 9.1-9.3. Adjusting of voltage generators 9.1-9.3, i.e., biasing of switching elements 8.1-8.3, is controlled by means of stored bias conditions for each covered frequency band, which are provided by memory means 11 from look-up table 12.

Alternatively or additionally, as already stated above, bias conditions for each switching element 8.1-8.3 can be provided by analysing output signal S' by means of analysing means 13. Analysing means 13 is devised for analysing output signal S' provided via feedback path 14. For instance, analysing means 13 may comprise a data processing unit (not shown) configured to optimise performance of amplifier stage 1 for every covered frequency by suitably biasing switching elements 8.1-8.3 via biasing means 9.1-9.3.

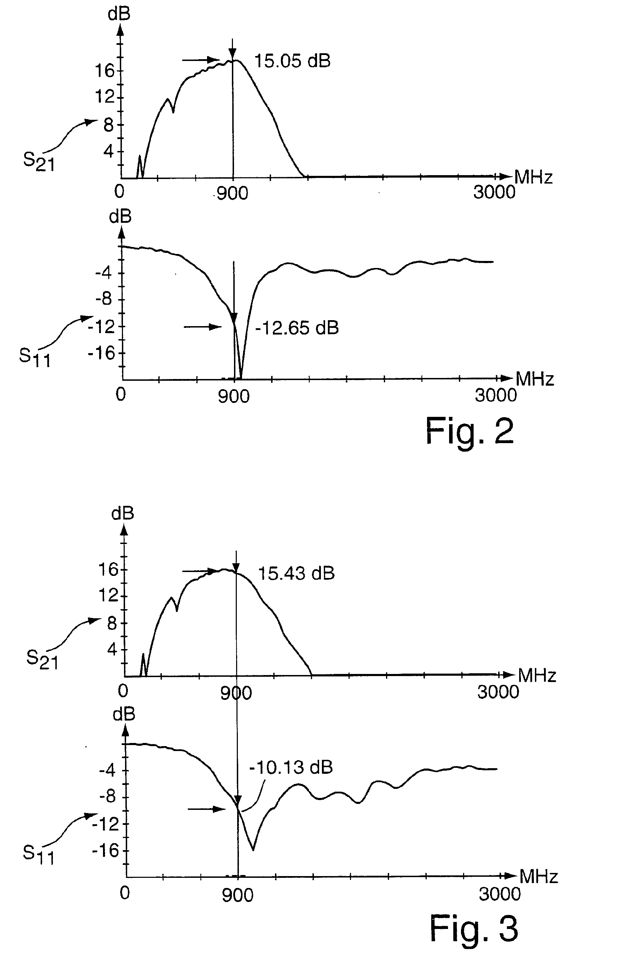

In amplifier stage 1 of Fig. 1, input reflection S₁₁, i.e., reflection of signal S at input 2, and gain S₂₁ (transmission) of the adaptive matching network are mainly dependent on the biasing of the switching elements (PIN diodes) 8.1-8.3. In this way, in accordance with the present invention performance of amplifier stage 1 can be controlled through the biasing of said switching elements. In appended Figs. 2 and 3 input reflection S₁₁ and gain S₂₁ are illustrated in exemplary fashion for two different biasing conditions.

Fig. 2 shows input reflection and gain of the amplifier stage of Fig. 1 for a first bias condition at a given frequency. The upper panel of Fig. 2 shows gain S₂₁ (transmission) and the lower panel of Fig. 2 shows input reflection S₁₁ of an exemplary single-stage multi-band amplifier with adaptive matching network, i.e. amplifier stage 1 of Fig. 1, at 900 MHz.

In the example of Fig. 2, the switching element (PIN diode) related to a frequency of 900 MHz is biased with V_{diode} = -4 V (diode in On-state). Consequently, the amplifier provides gain S₂₁ of approximately 17 dB with an input reflection S₁₁ of approximately -12.6 dB.

Fig. 3 shows input reflection and gain of the amplifier stage of Fig. 1 for a second bias condition at a given frequency. In the example of Fig. 3 diode biasing has been changed from V_{diode} = -4 V to V'_{diode} = -0.8 V (diode between On- and Off-state). As can be gathered from the upper panel in Fig. 3, gain S₂₁ is reduced by approximately 1.5 dB to a value of approximately 15.4 dB with a related input reflection S₁₁ of approximately -10 dB, which is still satisfactory for the envisaged applications.

As stated above, diagrams of Figs. 2 and 3 show the characteristics of amplifier stage 1 (Fig. 1) during operation at 900 MHz. By suitably biasing, e.g., the PIN diode related to a frequency of 2500 MHz (not shown in Figs. 2 and 3), an increased gain value range of, e.g., 2 dB can be achieved. For instance, with V_{diode} = -4 V (diode in On-state) S₂₁ = 8.2 dB, and S₁₁ = -19.2 dB. Furthermore, for V'_{diode} = -0.8 V (diode between On- and Off-state) S₂₁ = 6 dB and S₁₁ = -18.2 dB.

Furthermore, the PIN diode can also be biased in a deeper Off-state, i.e. V'_{diode} > -0,8 V, such that a gain value range of > 2 dB can be achieved.

As will be appreciated by a person skilled in the art the above-mentioned biasing conditions are given by way of example only. Different values and signs may be used, also depending on the switching elements employed.

Since gain generally decreases with increased frequency, a lower maximum of the gain has to be expected for the 2500 MHz band when compared to the 900 MHz band.

Based on the adjustable gain range described above, which can be further increased by using amplifier stages in accordance with the embodiment of Fig. 1 for pre-, driver- and final amplifier stages within a multi-stage amplifier module, the final amplifier of a multi-band/multi-standard BTS can be driven close to its optimum output power level for each different frequency band, while meeting specifications such as 3GPP ACLR (Adjacent Channel Leakage Power Ratio).

As will be appreciated by a person skilled in the art, amplifier efficiency mainly depends on the back-off from the 1 dB compression point (P1 dB), such that the above-described approach also provides a possibility to increase efficiency of the complete (multi-stage) amplifier module.

By storing appropriate frequency-related PIN diode biasing conditions in look-up table 12 (Fig. 1) and/or by analysing the output signal S' through feedback path 14 and analysing means 13 (Fig. 1), performance of the amplifier stage (amplifier module) can be optimised for each covered frequency.

Thus, in summary, embodiments of the present invention provide a cost-effective solution for improved power amplifier module performance with respect to gain characteristics, output power, and amplifier efficiency.

## Claims

1. A method of controlling gain of an amplifier (1), comprising:
- providing an adaptive matching network with a plurality of adaptive matching branches (6.1, 6.2, 6.3), each adaptive matching branch being intended for a specific frequency;
- biasing a first adaptive matching element (8.1, 8.2, 8.3) comprised in an adaptive matching branch (6.1, 6.2, 6.3) for a given frequency in a first state;
- biasing respective adaptive matching elements (8.1, 8.2, 8.3) comprised in adaptive matching branches (6.1, 6.2, 6.3) for other frequencies in a second state.

2. The method of claim 1, **characterised in that** at least one of said adaptive matching elements (8.1, 8.2, 8.3) is a switching element and that said first state of said switching element is an On-state or an intermediate state between an On-state and an Off-state.

3. The method of claim 1, **characterised in that** at least one of said adaptive matching elements (8.1, 8.2, 8.3) is a switching element and that said second state is an Off-state.

4. The method of claim 1, further comprising determining a biasing condition of at least one of the adaptive matching elements (8.1, 8.2, 8.3) from a look-up table (12).

5. The method of claim 1, further comprising analysing an output signal (S') of the amplifier (1) to determine a biasing condition of at least one of the adaptive matching elements (8.1, 8.2, 8.3).

6. An amplifier stage (1), in particular for amplifying RF signals (S), comprising:
- an input (2) for inputting a signal (S) to be amplified;
- an output (3) for outputting an amplified signal (S');
- an amplifying element (5) located in a signal transmission path (4) between said input (2) and said output (3);
- an adaptive matching network with a plurality of adaptive matching branches (6.1, 6.2, 6.3), each adaptive matching branch being intended for a specific frequency;
further comprising in each adaptive matching branch:
- a switching element (8.1, 8.2, 8.3) for activating/deactivating the respective adaptive matching branch (6.1, 6.2, 6.3) or a tuneable element for adjustment of a suitable matching of a respective matching branch; and
- biasing means (9.1, 9.2, 9.3) for biasing said switching elements (8.1, 8.2, 8.3) or said tuneable elements in at least a first and a second state.

7. The amplifier stage (1) of claim 6, further comprising means (9.1, 9.2, 9.3; 11, 12; 13, 14) for controlling a biasing condition of said switching elements (8.1, 8.2, 8.3) or said tuneable elements.

8. The amplifier stage (1) of claim 6, **characterised in that** said switching elements (8.1, 8.2, 8.3) are diodes, in particular PIN diodes.

9. A transmitter, in particular radio transmitter, comprising at least one amplifier stage (1) according to any one of claims 6 to 8.

10. A base station or mobile terminal for use in a communication network, comprising at least one transmitter according to claim 9.
